# EUROPEAN PATENT SPECIFICATION

(11) **EP 3 845 385 B1**
(45) Date of publication and mention of the grant of the patent: **19.10.2022**
(21) Application number: 18931918.9
(22) Date of filing: 27.08.2018
(51) Int. Cl.: B41F 15/08, B41F 15/36, H05K 3/12

(54) **SOLDER PRINTING MACHINE**
LÖTDRUCKGERÄT
MACHINE D'IMPRESSION DE SOUDURE

(43) Date of publication of application: 07.07.2021
(73) Proprietor: FUJI Corporation, Chiryu-shi, Aichi 472-8686 (JP)
(72) Inventor: KONDO, Takeshi, Chiryu-shi, Aichi 472-8686 (JP)
(74) Representative: Grünecker Patent- und Rechtsanwälte PartG mbB
(86) International application number: PCT/JP2018/031496
(87) International publication number: WO 2020/044388

(56) References cited:
- WO-A1-2004/098887
- WO-A1-2018/127966
- JP-A- 2005 319 743
- JP-A- 2008 307 830
- JP-A- 2012 101 406
- JP-U- H01 141 027
- US-A- 5 241 187
- US-A1- 2014 261 027

## Description

### Technical Field

The present invention relates to a solder printing machine which, by adhering creamy solder to a board, prints a pattern of the solder on the board.

### Background Art

As described in Patent Literature 1, a general solder printing machine includes a board holding device configured to hold the board, a mask holding device configured to hold a mask provided with multiple openings and coming into contact with a top surface of the board during printing, a squeegee device including a squeegee and configured to cause the creamy solder supplied to an upper surface of the mask to adhere to the board held by the board holding device through the multiple openings by causing the squeegee to move over the upper surface of the mask, an imaging device configured to image the top surface of the mask to acquire a board-facing mask position, which is a position of the mask held by the mask holding device and is a position along one plane parallel to the top surface of the board relative to the board held by the board holding device, a position adjusting device which adjusts the board-facing mask position by moving the mask held by the mask holding device relative to the board holding device during the printing, and a control device for controlling the solder printing machine, in which the solder printing machine is configured to adjust the board-facing mask position using the position adjusting device during the printing.

### Patent Literature

Patent Literature 1: JP-A-2017-154445
Patent Literature 2: US 5 241 187 A discloses a registration (alignment) method for screen printing, wherein before printing a registration hole formed in a print object is aligned with a reference mark on an extensible screen forming a mask. With a CCD camera, the reference mark on the screen is detected from below through the registration hole so that a shift amount between the mark and the hole can be directly measured.

### Summary of the Invention

### Technical Problem

In recent years, the micro processing of openings provided in the mask has advanced, and with it, the mask has become thinner. To maintain the flatness of the mask when the mask is separated from the board after completion of printing, that is, during the plate releasing, tension is applied to the mask, but it is necessary to apply larger tension as the mask becomes thinner. Large tension is a cause of distortion in the mask, and when the temperature variation in the solder printing machine is large, the distortion increases. When a large distortion occurs in the mask, it becomes difficult to adjust a board-facing mask position which may lead to printing failure. Therefore, obtaining the distortion of the mask and adjusting the board-facing mask position in consideration of the distortion contributes to improving the practicability of the solder printing machine. The present invention has been made with consideration to such circumstances, and an object thereof is to provide a highly practical solder printing machine.

### Solution to Problem

To solve the above-mentioned problems, a solder printing machine according to the present invention as defined in claim 1 is provided.

Further preferred embodiments are defined in the dependent claims.

The solder printing machine of the present invention is featuring the control device configured to acquire an intra-mask positional deviation, which is a deviation of a specific location on the mask, based on captured image data of the imaging device, between any of the multiple openings or a specific mark provided at the specific location of the mask, and two or more fiducial marks provided on the mask.

### Advantageous Effect of the Invention

With the solder printing machine of the present invention, by acquiring the intra-mask positional deviation which is the deviation of a specific location, it is possible to obtain the distortion of the mask, and, based on the intra-mask positional deviation, it is possible to appropriately adjust the board-facing mask position. As a result, the solder printing machine of the present invention becomes highly practical.

### Brief Description of Drawings

Fig. 1 is a perspective view illustrating a component mounting line in which a solder printing machine of an embodiment is deployed.
Fig. 2 is a perspective view illustrating the solder printing machine in a state in which an exterior panel is removed.
Fig. 3 is a perspective view illustrating a board conveyance conveyor device, a board holding and lifting/lowering device, and a mark imaging device configuring the solder printing machine.
Fig. 4 is a perspective view illustrating a board conveyance conveyor device, a board holding and lifting/lowering device, and a cleaning device configuring the solder printing machine.
Fig. 5 is a perspective view illustrating a mask holding device, a position adjusting device, and a squeegee device configuring the solder printing machine.
Fig. 6 is a diagram illustrating a mask used for printing a solder pattern on a board using the solder printing machine.
Fig. 7 is a flowchart illustrating a mask distortion determining and position adjusting program to be executed by a control device of the solder printing machine.

### Description of Embodiments

Hereinafter, a representative embodiment of the present invention will be described in detail with reference to the drawings as an embodiment.

### [EMBODIMENT]

### [A] Mounting Line in which Solder Printing Machine is Disposed

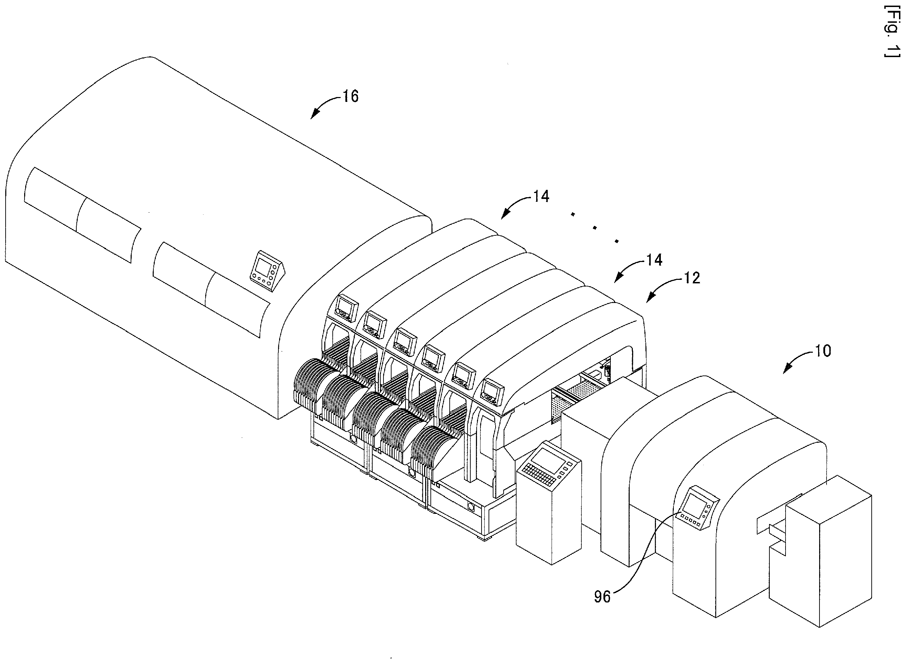

As illustrated in Fig. 1, solder printing machine 10 of the embodiment (hereinafter, sometimes abbreviated as "printing machine 10") is disposed in a mounting line, that is, in a line which mounts electronic components (hereinafter, sometimes abbreviated as "components") on a board to manufacture an electrical circuit. The mounting line, in addition to printing machine 10, is configured to include inspector 12, five component mounter 14, and reflow furnace 16. As will be described later in detail, printing machine 10 causes creamy solder (hereinafter, sometimes abbreviated as "solder") to adhere to the top surface of the board to print a pattern formed by the solder (hereinafter, sometimes referred to as "solder pattern"). Inspector 12 performs an inspection on the positional accuracy of the solder pattern printed by solder printing machine 10, the adhered solder amount, and the like. Component mounter 14 places components on the board on which the solder pattern is printed. Reflow furnace 16 fixes the component to the board by melting the solder of the board on which the components are placed and subsequently allowing the solder to solidify.

### [B] Configuration of Solder Printing Machine

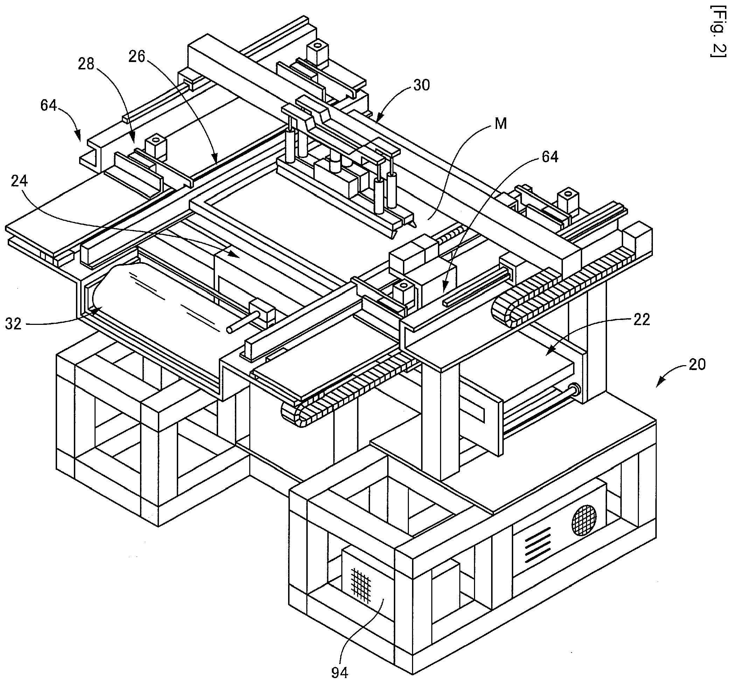

Fig. 2 illustrates printing machine 10 in a state in which the exterior panel is removed. Printing machine 10, including base frame 20 mainly composed of individual pipes, is configured by board conveyance conveyor device 22 arranged and supported by base frame 20, board holding and lifting/lowering device 24 (which is a kind of board holding device), mask holding device 26, position adjusting device 28, squeegee device 30, cleaning device 32, mark imaging device 34 (omitted from Fig. 2, is a kind of imaging device) and the like.

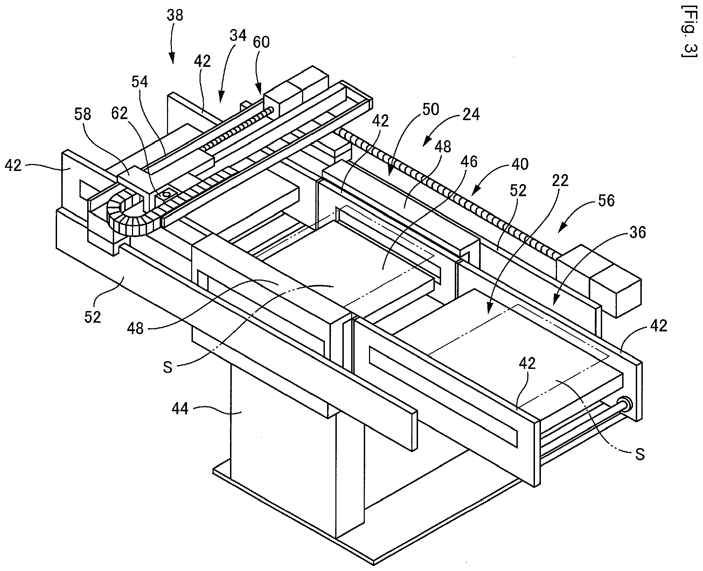

Fig. 3 illustrates board conveyance conveyor device 22 (hereinafter, may be simply referred to as "conveyor device 22"), board holding and lifting/lowering device 24, and mark imaging device 34. Conveyor device 22 is divided into three, loading section 36 positioned on the upstream side in the direction in which board S is conveyed, unloading section 38 positioned on the downstream side, and intermediate section 40 positioned between loading section 36 and unloading section 38. Loading section 36, unloading section 38, and intermediate section 40 each includes a pair of side plates 42 supported by base frame 20. A conveyor belt is held to be capable of circulating on opposing surfaces (omitted from Fig. 3) in each pair of side plates 42 and board S is carried in a state where both ends of board S are placed on the conveyor belts.

Board holding and lifting/lowering device 24 is provided with base 44 and backup base 46 supported by base 44 and positioned between the pair of side plates 42 of intermediate section 40 of conveyor device 22. It is possible to lift and lower backup base 46 using a backup base lifting and lowering mechanism arranged on base 44 and board S conveyed to a predetermined position of intermediate section 40 by conveyor device 22 is lifted from below by the lifting of conveyor device 22 itself. Board holding and lifting/lowering device 24 is provided with clamp 50 including a pair of pinching bodies 48 and supported on base 44, and clamp 50 pinches board S at the end portions thereof lifted by backup base 46. It is possible to lift and lower clamp 50 together with backup base 46 using a clamp lifting and lowering mechanism arranged on base 44 in a state in which clamp 50 pinches board S.

Mark imaging device 34 is arranged above conveyor device 22 and board holding and lifting/lowering device 24 and below mask holding device 26 to be interposed therebetween. Mark imaging device 34 includes a pair of guide rails 52 extending in the board conveyance direction, movable beam 54 extending horizontally in a direction perpendicular to the board conveyance direction (hereinafter, referred to as a "front-rear direction") and guided by the pair of guide rails 52 to be capable of moving in the board conveyance direction, beam moving mechanism 56 which causes movable beam 54 to move, slide 58 guided by movable beam 54 and capable of moving in the front-rear direction, slide moving mechanism 60 which causes slide 58 to move in the front-rear direction, and camera 62 held by slide 58. Camera 62 is capable of imaging both upward and downward, is moved in the left-right direction and the front-rear direction, and is capable of imaging position fiducial marks added at arbitrary positions on each of the top surface (specifically, the upper surface) of board S held by the board holding and lifting/lowering device 24 and the lower surface of mask M (refer to Fig. 2, sometimes referred to as "screen", "screen mask", "mask screen" or the like) held by mask holding device 26.

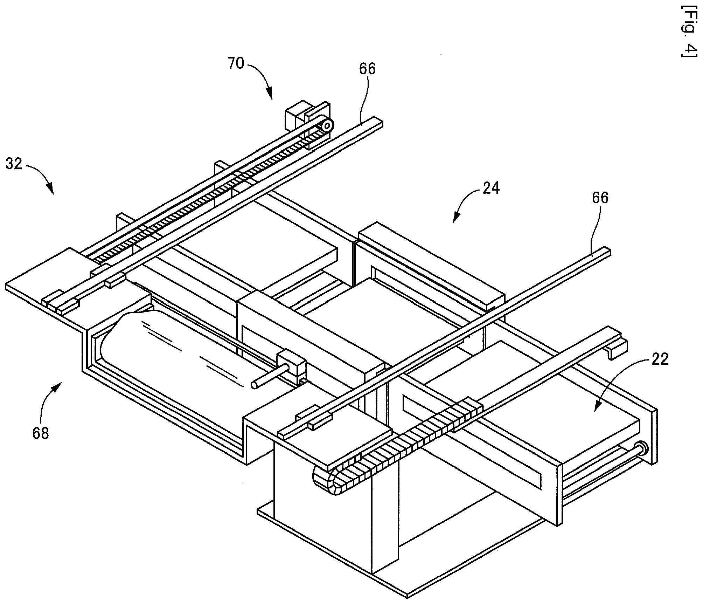

Fig. 4 illustrates conveyor device 22, board holding and lifting/lowering device 24, and cleaning device 32. Cleaning device 32 is arranged above mark imaging device 34 and below mask holding device 26 to be interposed therebetween. Cleaning device 32 is for cleaning the lower surface of mask M and includes a pair of guide rails 66 fixed to the lower surface of a pair of support beams 64 (each of which is formed by joining a channel-shaped member and a plateshaped member, refer to Fig. 2) which configure base frame 20 and extend in the front-rear direction, cleaning unit 68 guided by the pair of guide rails 66 and capable of moving in the front-rear direction, and cleaning unit moving mechanism 70 which causes cleaning unit 68 to move in the front-rear direction. Since cleaning unit 68 is well known, a description thereof will be omitted.

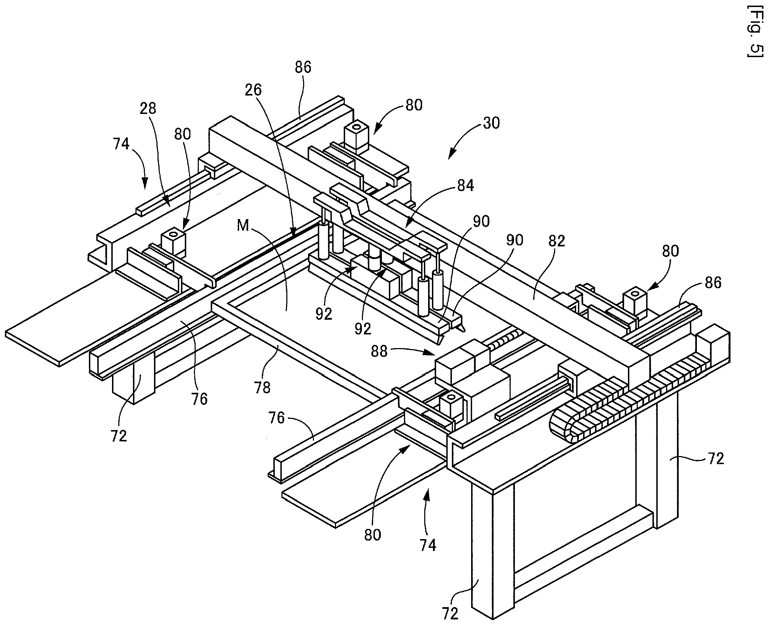

Fig. 5 illustrates mask holding device 26, position adjusting device 28, and squeegee device 30. Mask holding device 26, position adjusting device 28, and squeegee device 30 are supported on a pair of support beams 74 mounted on columns 72 that configure base frame 20. Mask holding device 26 includes a pair of holding rods 76 which are respectively supported by the pair of support beams 74. Mask M is attached to mask frame 78, and the pair of holding rods 76 holds mask frame 78. Incidentally, mask frame 78 is exchanged together with mask M when mask M is exchanged. Each of the pair of holding rods 76 includes a pair of adjustment mechanisms 80 which displace the positions of the two respective parts in the front-rear and left-right directions. Position adjusting device 28 is configured by the two pairs of adjustment mechanisms 80, the position adjustment (which is a concept including a rotational position adjustment, that is, orientation adjustment) of mask M is performed by position adjusting device 28. Specifically, position adjusting device 28 includes a function of adjusting the board-facing mask position which is the position of mask M along one plane parallel to the top surface of board S relative to board S held by the board holding and lifting/lowering device 24.

Squeegee device 30 is configured to include movable beam 82 and squeegee unit 84 held by movable beam 82. Both ends of movable beam 82 are supported by a pair of guide rails 86 provided on the pair of support beams 74 with movable beam 82 in an orientation extending in the left-right direction, and movable beam 82 is capable of moving in the front-rear direction. Movable beam 82 is caused to move by movable beam moving mechanism 88. Squeegee unit 84 is configured to include a pair of squeegees 90 disposed side by side to the front and rear, and a pair of squeegee lifting and lowering mechanisms 92 which lift and lower the pair of squeegees 90, respectively.

As will be described later in detail, multiple small openings are formed in mask M corresponding to multiple portions of the solder pattern. In a state where board S is in contact with the lower surface of mask M, due to the solder supplied to the upper surface of mask M being moved by squeegees 90 in a state where squeegees 90 are in contact with the upper surface of mask M and the openings formed in mask M are filled by the solder, the solder is caused to adhere to the board top surface through the openings, and the solder pattern is printed to be transcribed. Incidentally, the pair of squeegees 90 is alternately moved in different directions to print the solder pattern, and during the printing, the supplied solder moves along the top surface of mask M as if forming a roll-shape and rolling between the pair of squeegees 90.

Control of the operation of the above-described devices such as conveyor device 22 is performed by control device 94 arranged at the lower section of base frame 20 (refer to Fig. 2). Control device 94 has a computer as a central constituent element and is configured to include a driver (drive circuit) of each device. Operation panel 96 configured to include a display, an operation switch (refer to Fig. 1), and the like is connected to control device 94.

In the printing work by printing machine 10 configured as described above, first, board S to be subjected to printing work is received by loading section 36 of conveyor device 22, and through the cooperation of loading section 36 and intermediate section 40, board S is conveyed to a predetermined position of intermediate section 40, that is, to the printing work position. Next, due to backup base 46 of board holding and lifting/lowering device 24 being lifted, board S is lifted from the conveyor to a position which may be pinched by clamp 50, that is, to a clamping position and is pinched by clamp 50 at this position. In this state, camera 62 of mark imaging device 34 reads a board ID mark and a fiducial mark attached to the top surface (upper surface) of board S and reads a fiducial mark attached to the lower surface of mask M. The read information is processed by control device 94, while the ID of board S is recognized, the positional deviation amount between board S and mask M, that is, the board-facing mask position is recognized. Based on the recognized positional deviation amount, position adjusting device 28 adjusts the position of mask M aligned with the position of board S, that is, adjusts the board-facing mask position. The adjustment of the board-facing mask position will be described in detail later.

After the adjustment of the board-facing mask positions, board S remains pinched by clamp 50 and is lifted together with backup base 46 to a position where board S hits the lower surface of mask M. In a state where board S is lifted to the position, the printing of the solder pattern is performed by squeegee device 30. Specifically, normally, the printing is performed by squeegee unit 84 being moved once from the front to the rear or from the rear to the front in a state in which one of the pair of squeegees 90 abuts against the upper surface of mask M. Board S in which this operation, that is, the printing is completed, is lowered to the clamping position together with backup base 46, the pinching by clamp 50 is released at this position, and subsequently, board S is placed on the conveyor by backup base 46 being further lowered. Thereafter, board S is conveyed to unloading section 38 through the cooperation of intermediate section 40 and unloading section 38 of conveyor device 22, and is unloaded to the downstream side of printing machine 10 by unloading section 38. Information on the recognized ID is transmitted together with print completion information.

### [C] Mask Distortion Problem

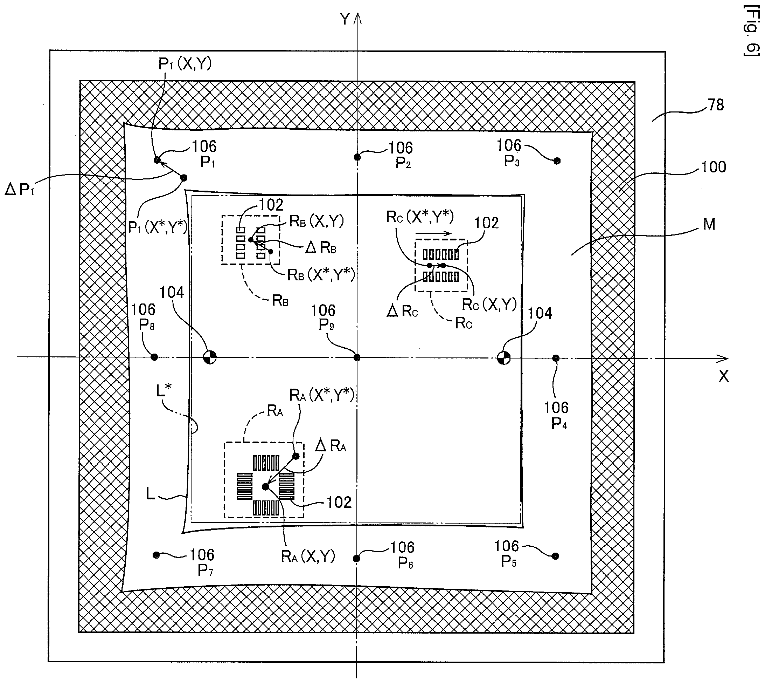

Mask M is generally made of considerably thin stainless steel having a rectangular shape, and as illustrated in Fig. 6, four sides are held in mask frame 78. Board S is held in a taut state to be detached from board S after printing, that is, so that the plate releasing is favorable. In other words, tension is applied in a direction along a plane parallel to the top surface of mask M. The outer peripheral portion is formed as mesh 100 so that the tension is appropriate. Openings 102 for printing the solder pattern are formed in the center section. Incidentally, multiple openings 102 are formed in mask M, but only a portion thereof is drawn in the figure, and the others are omitted.

As described above, mask M is provided with fiducial marks 104 corresponding to fiducial marks on board S. In one example, two fiducial marks of board S are provided at the center of the two mutually opposing sides of board S and two fiducial marks 104 of mask M are provided at positions corresponding respectively to the fiducial marks of board S.

Mask M is predicted to be distorted because of the considerable thinness of mask M, that multiple openings 102 are formed in mask M, and the tension applied to mask M. Fig. 6 illustrates, in an exaggerated manner, a state where mask M is distorted so that theoretical shape L* of board S illustrated by the two-dot chain line is the shape illustrated by solid line L. Such distortion causes deviation of openings 102, which leads to worsening of the positional accuracy of the printed solder pattern.

Further describing the distortion of mask M, when distortion occurs in mask M, the position of the specific location of mask M in a plane along the top surface of mask M is displaced. In printing machine 10, when a plane along the top surface of mask M is an XY-plane and XY coordinates (an axis parallel to the line segment is the X-axis and an axis perpendicular to the line segment is the Y-axis) are regulated with the middle point of a line connecting two fiducial marks 104 as the origin, the displacement of the actual coordinate position (X, Y) of the specific location on mask M relative to the theoretical coordinate position (X*, Y*) is acknowledged as the deviation in the XY-plane of mask M of the specific location, that is, the intra-mask positional deviation (actually, the distance between the theoretical coordinate position and the actual coordinate position). Printing machine 10 acquires the intra-mask positional deviation of several locations, adjusts the position of mask M relative to board S during printing based on the obtained intra-mask positional deviation, that is, adjusts the board-facing mask position, and when the intra-mask positional deviation of any of the locations is increased to some extent, the outside is to be notified of this fact.

Incidentally, in mask M illustrated in Fig. 6, nine distortion determined locations P₁ to P₉ are set as specific locations for determining the degree of distortion of mask M and are provided respectively with distortion determination marks 106 serving as specific marks, separately from fiducial marks 104 described above. Three management regions R_{A}, R_{B}, and Rc are set as specific locations for managing the deviation of the solder pattern in board S after the printing. Each of the management regions is a position at which it is assumed that distortion of mask M is likely to occur. Regarding the solder pattern of openings 102 in the management region R_{A}, particularly high accuracy is required for the printing position on board S.

In the drawing, the theoretical coordinate positions of the management regions R_{A}, R_{B}, and Rc are denoted as R_{A} (X*, Y*), R_{B} (X*, Y*), and Rc (X*, Y*), respectively, the actual coordinate positions as R_{A} (X, Y), and R_{B} (X, Y), and Rc (X, Y), respectively, and the intra-mask positional deviation as ΔR_{A}, ΔR_{B}, and ΔR_{C}, respectively. Also for distortion determined locations P₁ to P₉, the theoretical coordinate positions are denoted as P₁ (X*, Y*) to P₉ (X*, Y*), respectively, the actual coordinate positions as P₁ (X, Y) to P₉ (X, Y), and the intra-mask positional deviation as ΔP₁ to ΔP₉, respectively, but are omitted from the drawing. Incidentally, intra-mask positional deviations ΔR_{A}, ΔR_{B}, and ΔR_{C} of management regions R_{A}, R_{B}, and Rc are, although exaggerated in the drawing, indicated to be ΔR_{A} > ΔR_{B} > ΔR_{C}. In the drawings, for only distortion determined location Pi, theoretical coordinate position P₁ (X*, Y*) becomes actual coordinate position P₁ (X, Y), indicating that intra-mask positional deviation ΔP₁ is present, but intra-mask positional deviations ΔP₁ to ΔP₉ and the like for the other distortion determined locations P₁ to P₉ are omitted.

### [D] Processing Performed by Control Device in relation to Distortion of Mask

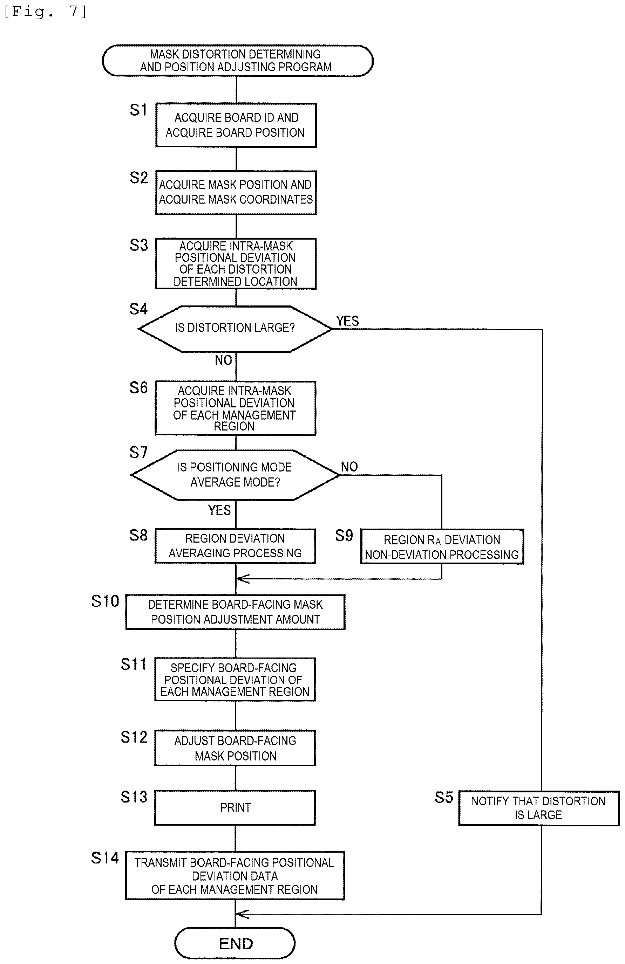

When performing the printing, control device 94 executes a mask distortion determining and position adjusting program illustrating a flowchart in Fig. 7 when board S is pinched by clamp 50. Hereinafter, following the flowchart, a description will be given of the processing to be executed by control device 94 relating to the acquisition of the intra-mask positional deviation, the adjustment of the board-facing mask position, and the like.

In the processing following the mask distortion determining and position adjusting program, first, in step 1 (hereinafter, abbreviated as "S1 ", the same applies to the other steps), the board ID mark attached to the clamped board S is imaged by mark imaging device 34, the ID of board S is acquired, the fiducial marks of board S are imaged by mark imaging device 34, and the position (which is a concept including a rotational orientation) of the clamped board S is acquired based on the captured image data obtained by the imaging. In the subsequent S2, fiducial marks 104 attached to mask M are imaged by mark imaging device 34, and based on the captured image data obtained by the imaging, the position (which is a concept also including a rotational orientation) of mask M is acquired and the XY coordinates described above, that is, the mask coordinates are set.

Subsequently, in S3, distortion determined locations P₁ to P₉ are imaged by mark imaging device 34 and the positional deviations of distortion determined locations P₁ to P₉ in the mask coordinates, that is, intra-mask positional deviations ΔP₁ to ΔP₉ of distortion determined locations P₁ to P₉ are acquired. Next, in S4, it is determined whether the distortion of mask M is large. Specifically, when any of the acquired intra-mask positional deviations ΔP₁ to ΔP₉ is greater than or equal to set value (threshold value) ΔP_{TH}, it is determined that the distortion of mask M is large. When it is determined that the distortion of mask M is large, the operator is notified of the fact via operation panel 96 in S5.

When it is determined that the distortion of the mask is not large, in S6, management regions R_{A}, R_{B}, and Rc are imaged by mark imaging device 34 and the positional deviation in the mask coordinates of the management regions R_{A}, R_{B}, and R_{C}, that is, the intra-mask positional deviations ΔR_{A}, ΔR_{B}, and ΔR_{C} are acquired. Incidentally, no specific marks are attached to the management regions R_{A}, R_{B}, and R_{C}, openings 102 present in management regions ΔR_{A}, ΔR_{B}, and ΔR_{C} are imaged, and the intra-mask positional deviations of the imaged openings 102 are acknowledged as intra-mask positional deviations ΔR_{A}, ΔR_{B}, and ΔR_{C} in management regions R_{A}, R_{B}, and Rc.

In printing machine 10, as modes (hereinafter, sometimes referred to as "positioning mode") for adjusting the position of mask M relative to board S, that is, the board-facing mask position, two modes, specifically, a weighted mode and an average mode are prepared. Either of these modes is set for the printing work using mask M. The average mode is a mode in which mask M is positioned relative to board S such that the board-facing positional deviations of each of the three management regions R_{A}, R_{B}, and R_{C} are averaged, in particular, such that the average of the board-facing positional deviations of the three management regions R_{A}, R_{B}, and R_{C} is as small as possible, and the weighted mode is a mode in which mask M is positioned relative to board S such that the board-facing positional deviation of the region in which the highest precision is demanded for the printing position of the solder pattern, that is, of management region R_{A} in mask M depicted in Fig. 6 is 0. For the other management regions in the weighted mode, mask M is positioned relative to board S such that the board-facing positional deviations of the management regions are as small as possible. Specifically, in mask M illustrated in Fig. 6, mask M is positioned relative to board S such that the average of the board-facing positional deviations of management regions R_{B} and R_{C} is as small as possible. Further, if mask M is determined to not have large distortion according to the determination of intra-mask positional deviations ΔP₁ to ΔP₉ of distortion determined locations P₁ to P₉, when mask M is positioned on board S in the average mode, since none of the board-facing positional deviations of management regions R_{A}, R_{B}, and Rc become larger than a certain value, in the average mode, mask M is positioned relative to board S such that the board-facing positional deviation is less than or equal to a set value in all of the multiple management regions.

In the processing following the present program, in S7, it is determined whether the positioning mode is set to the average mode or the weighted mode. When the positioning mode is set to the average mode, in S8, the board-facing mask position, more specifically, the adjustment amount δ (X, Y, θ) (hereinafter, sometimes referred to as "board-facing mask position adjustment amount", which may be considered as the respective correction amounts of the X direction, the Y direction, and the rotational direction) for adjusting the board-facing mask position is determined by calculation so that the respective board-facing positional deviations of management regions R_{A}, R_{B}, and Rc are averaged. On the other hand, when the positioning mode is set to the weighted mode, in S9, the board-facing mask position adjustment amount is determined by calculation so that the board-facing positional deviation of management region R_{A} is 0. In S8 and S9, the calculation of the board-facing mask position adjustment amount is performed based on the position of board S acquired in S1 and S2 and the position of mask M. Details of the calculation may be simply performed according to a mathematical method, and therefore description thereof will be omitted.

Next, in S10, the board-facing mask position adjustment amount obtained in S8 or S9 is determined as the board-facing mask position adjustment amount in the current printing work, and in S11, the board-facing positional deviation of each of management regions R_{A}, R_{B}, and R_{C}, in a case where the positioning of mask M is performed using the board-facing mask position adjustment amount, is specified.

Then, in S12, based on the determined board-facing mask position adjustment amount, position adjusting device 28 is caused to perform the position adjustment on board S of mask M, and after the position adjustment, the printing is performed in S13. Specifically, control device 94 causes board holding, lifting/lowering device 24 to lift board S and causes the solder to adhere to board S using squeegee device 30.

After the printing, in S14, data on the board-facing positional deviation of each of the specified management regions R_{A}, R_{B}, and R_{C} is transmitted, together with the board ID acquired in S1, to inspector 12 and component mounter 14 disposed on the downstream side, and one execution of the mask distortion determining and position adjusting program is completed. The transmitted data, for example, is used for setting the threshold value in making a pass/fail determination for the positional accuracy of the solder pattern in inspector 12 and is used for improving the mounting accuracy of the components in component mounter 14.

In the processing following the program described above, distortion determination marks, which are specific marks, are used in the determination using intra-mask positional deviations ΔP₁ to ΔP₉ of distortion determined locations P₁ to P₉; however, a configuration may be adopted in which locations at which some of openings 102 are provided are set as the distortion determined locations and the intra-mask positional deviations of openings 102 are acquired based on the captured image data obtained by the imaging of openings 102. In the processing following the program described above, when acquiring the intra-mask positional deviation of the management region, the captured image data obtained by imaging openings 102 in the region is used; however, a configuration may be adopted in which a specific mark is provided in the region and the captured image data obtained by imaging the mark is used to acquire the intra-mask positional deviation of the region.

### Reference Signs List

10: solder printing machine, 20: base frame, 22: board conveyance conveyor device, 24: board holding and lifting/lowering device [board holding device], 26: mask holding device, 28: position adjusting device, 30: squeegee device, 34: mark imaging device [imaging device], 78: mask frame, 90: squeegee, 94: control device, 96: operation panel, 100: mesh, 102: opening, 104: fiducial mark, 106: distortion determination mark [specific mark], M: mask, S: board, R_{A}, R_{B}, R_{C}: management regions, P₁ to P₉: distortion determined locations, ΔR_{A}, ΔR_{B}, ΔR_{C}, ΔP₁ to ΔP₉: intra-mask positional deviations, δ (X, Y, θ): board-facing mask position adjustment amount

## Claims

1. A solder printing machine (10) which causes creamy solder to adhere to a board (S) to print a pattern on the board (S) using the solder, the machine (10) comprising:
a board holding device (24) configured to hold the board (S);
a mask holding device (26) configured to hold a mask (M) provided with multiple openings (102) and coming into contact with a top surface of the board (S) during printing;
a squeegee device (30), including a squeegee (90), which is configured to cause the creamy solder, being supplied to an upper surface of the mask (M), to adhere to the board (S) held by the board holding device (24) through the multiple openings (102) by causing the squeegee (90) to move over the upper surface of the mask (M);
an imaging device (34) configured to image the lower surface of the mask (M) to acquire a board-facing mask position (X, Y, θ), which is a position of the mask (M) held by the mask holding device (26) and is a position along one plane parallel to the top surface of the board (S) held by the board holding device (24);
a position adjusting device (28) which adjusts the board-facing mask position (X, Y, θ) by moving the mask (M) held by the mask holding device (26) relative to the board holding device (24) during the printing; and
a control device (94) for controlling the solder printing machine (10),
**characterized in that**
the control device (94) is configured to acquire an intra-mask positional deviation (ΔR_{A}, ΔR_{B}, ΔR_{C}, ΔP₁ to ΔP₉), which is a deviation of a specific location (R_{A}, R_{B}, R_{C}, P1 to P9) on the mask (M), based on captured image data of the imaging device (34), between any of the multiple openings (102) or a specific mark (106) provided at the specific location (R_{A}, R_{B}, R_{C}, P1 to P9) of the mask (M), and two or more fiducial marks (104) provided on the mask (M).

2. The solder printing machine (10) according to claim 1, wherein
the control device (94) is configured to adjust the board-facing mask position (X, Y, θ) using the position adjusting device (28) so that a board-facing positional deviation, which is a positional deviation between the specific location (R_{A}) with the intra-mask positional deviation (ΔR_{A}) on the mask and a location on the board (S) corresponding to the theoretical specific location (R_{A}) without the intra-mask positional deviation (ΔR_{A}), becomes less than or equal to a set value based on the intra-mask positional deviation (ΔR_{A}) of the specific location (R_{A}) during the printing.

3. The solder printing machine (10) according to claim 1, wherein
multiple locations (R_{A}, R_{B}, R_{C}), each serving as the specific location, are set in the mask (M), and
the control device (94) is configured to adjust the board-facing mask position (X, Y, θ) using the position adjusting device (28) so that a board-facing positional deviation, which is a positional deviation between one of the multiple locations (R_{A}, R_{B}, R_{C}) with the intra-mask positional deviation (ΔR_{A}, ΔR_{B}, ΔR_{C}) on the mask and a location on the board (S) corresponding to the theoretical one location (R_{A}, R_{B}, R_{C}) without the intra-mask positional deviation (ΔR_{A}, ΔR_{B}, ΔR_{C}), becomes less than or equal to a set value at all of the multiple locations (R_{A}, R_{B}, R_{C}) based on the intra-mask positional deviation (ΔR_{A}, ΔR_{B}, ΔR_{C}) of each of the multiple locations (R_{A}, R_{B}, R_{C}) during the printing.

4. The solder printing machine (10) according to claim 1, wherein
multiple locations (R_{A}, R_{B}, R_{C}), each serving as the specific location, are set in the mask (M), and
the control device (94) is configured to adjust the board-facing mask position (X, Y, θ) using the position adjusting device (28) so that board-facing positional deviations, which are positional deviations between each of the multiple locations (R_{A}, R_{B}, R_{C}) with the intra-mask positional deviation (ΔR_{A}, ΔR_{B}, ΔR_{C}) on the mask and locations on the board (S) corresponding to each of the theoretical multiple locations (R_{A}, R_{B}, R_{C}) without the intra-mask positional deviation (ΔR_{A}, ΔR_{B}, ΔR_{C}), are averaged based on the intra-mask positional deviation (ΔR_{A}, ΔR_{B}, ΔR_{C}) of each of the multiple locations (R_{A}, R_{B}, R_{C}) during the printing.

5. The solder printing machine (10) according to any one of claims 2 to 4, wherein the control device (94) is configured to transmit data on the board-facing mask position (X, Y, θ) adjusted during the printing outside of the solder printing machine to an inspector (12) and a component mounter (14) disposed on the downstream side.

6. The solder printing machine (10) according to any one of claims 1 to 5, wherein the control device (94) is configured to, when the acquired intra-mask positional deviation (ΔR_{A}, ΔR_{B}, ΔR_{C}, ΔP₁ to ΔP₉) is greater than or equal to a threshold value (ΔP_{TH}), send a notification thereof outside of the solder printing machine to an operation panel (96).

## Patentansprüche

1. Lotdruckmaschine (10), die bewirkt, dass cremiges Lötmittel auf einer Platine (S) haftet, um unter Verwendung des Lötmittels ein Muster auf die Platine (S) zu drucken, wobei die Maschine (10) Folgendes umfasst:
eine Platinenhaltevorrichtung (24), die dazu konfiguriert ist, die Platine (S) zu halten;
eine Maskenhaltevorrichtung (26), die so konfiguriert ist, dass sie eine Maske (M) hält, die mit mehreren Öffnungen (102) versehen ist und während des Druckens mit einer oberen Oberfläche der Platine (S) in Kontakt kommt;
eine Rakelvorrichtung (30), die eine Rakel (90) enthält, die konfiguriert ist, um zu bewirken, dass das cremige Lötmittel, das einer oberen Oberfläche der Maske (M) zugeführt wird, durch die mehreren Öffnungen (102) an der von der Platinenhaltevorrichtung (24) gehaltene Platine (S) haftet, indem bewirkt wird, dass sich die Rakel (90) über die obere Oberfläche der Maske (M) bewegt;
eine Abbildungsvorrichtung (34), die dazu konfiguriert ist, die untere Oberfläche der Maske (M) abzubilden, um eine der Platine zugewandte Maskenposition (X, Y, θ) zu erfassen, die eine Position der von der Maskenhaltevorrichtung (26) gehaltene Maske (M) ist, und eine Position entlang einer Ebene parallel zur oberen Oberfläche der von der Platinenhaltevorrichtung (24) gehaltene Platine (S) ist;
eine Positionseinstellvorrichtung (28), die die der Platine zugewandte Maskenposition (X, Y, θ) durch Bewegen der durch die Maskenhaltevorrichtung (26) gehaltenen Maske (M) relativ zu der Platinenhaltevorrichtung (24) einstellt während des Druckens; und
eine Steuereinrichtung (94) zum Steuern der Lotdruckmaschine (10),
**dadurch gekennzeichnet, dass**
die Steuervorrichtung (94) dazu konfiguriert ist, basierend auf erfassten Bilddaten der Abbildungsvorrichtung (34), eine Intramasken-Positionsabweichung (ΔR_{A}, ΔR_{B}, ΔR_{C}, ΔP₁ bis ΔP₉) zu erfassen, die eine Abweichung einer bestimmten Stelle (R_{A}, R_{B}, R_{C}, P₁ bis Pg) auf der Maske (M) ist, zwischen einer der mehreren Öffnungen (102) oder einer bestimmten Markierung (106), die an der bestimmten Stelle (R_{A}, R_{B}, R_{C}, P₁ bis Pg) der Maske (M) vorgesehen ist, und zwei oder mehr Bezugsmarkierungen (104), die auf der Maske (M) vorgesehen sind.

2. Lotdruckmaschine (10) nach Anspruch 1, wobei
die Steuervorrichtung (94) dazu konfiguriert ist, die der Platine zugewandten Maskenposition (X, Y, θ) unter Verwendung der Positionseinstellvorrichtung (28) so einzustellen, dass eine der Platine zugewandte Positionsabweichung, die eine Positionsabweichung zwischen der bestimmten Stelle (R_{A}) mit der Intramasken-Positionsabweichung (ΔR_{A}) auf der Maske und einer Stelle auf der Platine (S), der der theoretischen bestimmten Stelle (R_{A}) ohne die Intramasken-Positionsabweichung (ΔR_{A}) entspricht, kleiner oder gleich einem eingestellten Wert wird, basierend auf der Intramasken-Positionsabweichung (ΔR_{A}) der bestimmten Stelle (R_{A}) während des Druckens.

3. Lotdruckmaschine (10) nach Anspruch 1, wobei
mehrere Stellen (R_{A}, R_{B}, R_{C}), die jeweils als bestimmte Stelle dienen, in der Maske (M) gesetzt werden, und
die Steuervorrichtung (94) dazu konfiguriert ist, die der Platine zugewandte Maskenposition (X, Y, θ) unter Verwendung der Positionseinstellvorrichtung (28) so einzustellen, dass eine der Platine zugewandte Positionsabweichung, die eine Positionsabweichung zwischen einer der mehreren Stellen (R_{A}, R_{B}, R_{C}) mit der Intramasken-Positionsabweichung (ΔR_{A}, ΔR_{B}, ΔR_{C}) auf der Maske und eine Stelle auf der Platine (S) ist, die der theoretischen Stelle (R_{A}, R_{B}, R_{C}) ohne die Intramasken-Positionsabweichung (ΔR_{A}, ΔR_{B}, ΔR_{C}) entspricht, an allen der mehreren Stellen (R_{A}, R_{B}, R_{C}) kleiner oder gleich einem eingestellten Wert wird, basierend auf der Intramasken-Positionsabweichung (ΔR_{A}, ΔR_{B}, ΔR_{C}) von jeder der mehreren Stellen (R_{A}, R_{B}, R_{C}) während des Druckens.

4. Lotdruckmaschine (10) nach Anspruch 1, wobei
mehrere Stellen (R_{A}, R_{B}, R_{C}), die jeweils als bestimmte Stelle dienen, in der Maske (M) gesetzt werden, und
die Steuervorrichtung (94) dazu konfiguriert ist, die der Platine zugewandte Maskenposition (X, Y, θ) unter Verwendung der Positionseinstellvorrichtung (28) so einzustellen, dass der Platine zugewandte Positionsabweichungen, die Positionsabweichungen zwischen jedem der mehreren Stellen (R_{A}, R_{B}, R_{C}) mit der Intramasken-Positionsabweichung (ΔR_{A}, ΔR_{B}, ΔR_{C}) auf der Maske und Stellen auf der Platine (S), die jeder der theoretischen mehrere Stellen (R_{A}, R_{B}, R_{C}) ohne die Intramasken-Positionsabweichung (ΔR_{A}, ΔR_{B}, ΔR_{C}) entsprechen, basierend auf der Intramasken-Positionsabweichung (ΔR_{A}, ΔR_{B}, ΔR_{C}) jeder der mehreren Stellen (R_{A}, R_{B}, Rc) während des Druckens, gemittelt werden.

5. Lotdruckmaschine (10) nach einem der Ansprüche 2 bis 4, wobei
die Steuervorrichtung (94) dazu konfiguriert ist, die Daten über die während des Druckens eingestellte der Platine zugewandte Maskenposition (X, Y, θ) außerhalb der Lotdruckmaschine an einen Kontrolleur (12) und eine auf der stromabwärts gelegenen Seite angeordnete Komponentenmontagevorrichtung (14) zu übertragen.

6. Lotdruckmaschine (10) nach einem der Ansprüche 1 bis 5, wobei
die Steuervorrichtung (94) dazu konfiguriert ist, wenn die erfasste Intramasken-Positionsabweichung (ΔR_{A}, ΔR_{B}, ΔR_{C}, ΔP₁ bis ΔP₉) größer oder gleich einem Schwellenwert (ΔP_{TH}) ist, eine Benachrichtigung darüber an ein Bedienfeld (96) zu übersenden.

## Revendications

1. Machine d'impression de soudure (10) qui amène de la soudure en pâte à adhérer à une carte (S) dans le but d'imprimer un motif sur la carte (S) en utilisant la soudure, la machine (10) comprenant :
un dispositif de support de carte (24) configuré pour maintenir la carte (S),
un dispositif de support de masque (26) configuré pour maintenir un masque (M) pourvu de multiples ouvertures (102) et venant au contact de la surface supérieure de la carte (S) pendant l'impression,
un dispositif racloir (30) incluant un racloir (90) qui est configuré pour amener la soudure en pâte, délivrée sur la surface supérieure du masque (M), à coller à la carte (S) maintenue par le dispositif de support de carte (24) au travers des multiples ouvertures (102) en amenant le racloir (90) à se déplacer sur la surface supérieure du masque (M),
un dispositif de mise en image (34) configuré pour mettre en image la surface inférieure du masque (M) afin d'acquérir une position de masque faisant face à la carte (X, Y, θ) qui représente la position du masque (M) maintenu par le dispositif de support de masque (26) et qui est une position le long d'un plan parallèle à la surface supérieure de la carte (S) maintenue par le dispositif de support de carte (24),
un dispositif d'ajustement de position (28) qui ajuste la position de masque faisant face à la carte (X, Y, θ) en déplaçant le masque (M) maintenu par le dispositif de support de masque (26) par rapport au dispositif de support de carte (24) pendant l'impression, et
un dispositif de commande (94) destiné à piloter la machine d'impression de soudure (10),
**caractérisé en ce que :**
le dispositif de commande (94) est configuré pour acquérir un écart de position intra masque (ΔR_{A}, ΔR_{B}, ΔR_{C}, ΔP₁ à ΔP9) qui représente l'écart d'un emplacement spécifique (R_{A}, R_{B}, R_{C}, P1 à P9) sur le masque (M), sur la base de données d'image prise du dispositif de mise en image (34) entre l'une quelconque des multiples ouvertures (102) ou bien une marque spécifique (106) disposée à l'emplacement spécifique (R_{A}, R_{B}, R_{C}, P1 à P9) du masque (M), et deux marques d'alignement (104) ou plus disposées sur le masque (M) .

2. Machine d'impression de soudure (10) selon la revendication 1, dans laquelle :
le dispositif de commande (94) est configuré pour ajuster la position de masque faisant face à la carte (X, Y, θ) en utilisant le dispositif d'ajustement de position (28) de sorte à ce qu'un écart de position faisant face à la carte, qui est un écart de position entre l'emplacement spécifique (R_{A}) présentant l'écart de position intra masque (ΔR_{A}) sur le masque et un emplacement sur la carte (S) correspondant à l'emplacement théorique spécifique (R_{A}) sans l'écart de position intra masque (ΔR_{A}), devienne inférieur ou égal à une valeur fixée fondée sur l'écart de position intra masque (ΔR_{A}) de l'emplacement spécifique (R_{A}) pendant l'impression.

3. Machine d'impression de soudure (10) selon la revendication 1, dans laquelle :
de multiples emplacements (R_{A}, R_{B}, R_{C}) servant chacun d'emplacement spécifique, sont établis dans le masque (M), et
le dispositif de commande (94) est configuré pour ajuster la position de masque faisant face à la carte (X, Y, θ) en utilisant le dispositif d'ajustement de position (28) de sorte à ce qu'un écart de position faisant face à la carte, qui est un écart de position entre l'un des multiples emplacements (R_{A}, R_{B}, R_{C}) présentant l'écart de position intra masque (ΔR_{A}, ΔR_{B}, ΔR_{C}) sur le masque et un emplacement sur la carte (S) correspondant au dit emplacement théorique (R_{A}, R_{B}, R_{C}) sans écart de position intra masque (ΔR_{A}, ΔR_{B}, ΔR_{C}), devienne inférieur ou égal à une valeur fixée au niveau de la totalité des multiples emplacements (R_{A}, R_{B}, R_{C}) sur la base de l'écart de position intra masque (ΔR_{A}, ΔR_{B}, ΔR_{C}) de chacun des multiples emplacements (R_{A}, R_{B}, R_{C}) pendant l'impression.

4. Machine d'impression de soudure (10) selon la revendication 1, dans laquelle :
de multiples emplacements (R_{A}, R_{B}, R_{C}), servant chacun d'emplacement spécifique, sont établis dans le masque (M), et
le dispositif de commande (94) est configuré pour ajuster la position de masque faisant face à la carte (X, Y, θ) en utilisant le dispositif d'ajustement de position (28) de sorte à ce que les écarts de position faisant face à la carte, qui sont des écarts de position entre chacun des multiples emplacements (R_{A}, R_{B}, R_{C}) présentant l'écart de position intra masque (ΔR_{A}, ΔR_{B}, ΔR_{C}) sur le masque et des emplacements sur la carte (S) correspondant à chacun des multiples emplacements théoriques (R_{A}, R_{B}, R_{C}) sans écart de position intra masque (ΔR_{A}, ΔR_{B}, ΔR_{C}) font l'objet d'un calcul de moyenne sur la base de l'écart de position intra masque (ΔR_{A}, ΔR_{B}, ΔR_{C}) de chacun des multiples emplacements (R_{A}, R_{B}, R_{C}) pendant l'impression.

5. Machine d'impression de soudure (10) selon l'une quelconque des revendications 2 à 4, dans laquelle :
le dispositif de commande (94) est configuré pour transmettre des données concernant la position de masque faisant face à la carte (X, Y, θ), qui est ajustée pendant l'impression, à l'extérieur de la machine d'impression de soudure à un dispositif d'inspection (12) et à un dispositif de montage de composants (14) disposés en aval.

6. Machine d'impression de soudure (10) selon l'une quelconque des revendications 1 à 5, dans laquelle :
le dispositif de commande (94) est configuré, lorsque l'écart de position intra masque (ΔR_{A}, ΔR_{B}, ΔR_{C}, ΔP1 à ΔP9) acquis est supérieur ou égal à une valeur de seuil (ΔP_{TH}), pour envoyer une signalisation de cet état de fait à l'extérieur de la machine d'impression de soudure à un panneau de manœuvre (96).
